# DEMANDE DE BREVET EUROPEEN

(11) **EP 1 732 225 A1**
(43) Date de publication de la demande: **13.12.2006**
(21) Numéro de dépôt: 06300563.1
(22) Date de dépôt: 07.06.2006
(51) Int. Cl.: H03K 17/967, G06F 3/033

(54) **Dispositif de contrôle et/ou de commande d'équipements d'un véhicule automobile**

(30) Priorité: 07.06.2005 FR 0505771
(71) Demandeur: Peugeot Citroen Automobiles SA, 78943 Vélizy-Villacoublay Cedex (FR)
(72) Inventeur: Lebreton, Etienne, 92170 VANVES (FR)

(57) **Abrégé**

L'invention concerne un dispositif de contrôle et/ou de commande d'équipements d'un véhicule automobile.

Selon l'invention, le dispositif (1) comprend une dalle tactile (8) incluant une face active (7) en regard de laquelle sont disposées en façade de la planche de bord du véhicule des matrices (4) de boutons de contrôle et/ou de commande (3) des équipements (2), ces boutons (3) pouvant être sélectivement actionnés manuellement par un utilisateur pour produire une onde acoustique se propageant sur la face active (7), la dalle tactile (8) comprend, à sa face opposée à la face active (7) un ou plusieurs capteurs (11) de détection d'onde acoustique et une unité électronique de traitement (12) reliée aux capteurs (11) par un circuit imprimé (6) pour localiser la zone de la face active (7) d'où provient l'onde détectée et contrôler et/ou commander l'équipement (2) associés à cette zone.

L'invention trouve application dans le domaine automobile.

## Description

L'invention concerne un dispositif de contrôle et/ou de commande d'équipements d'un véhicule automobile.

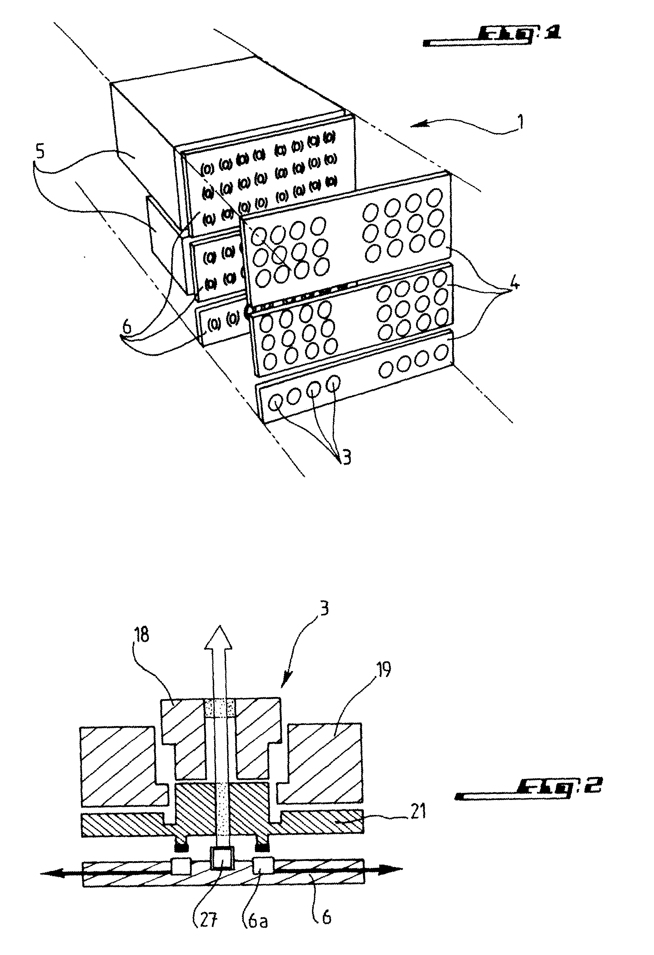

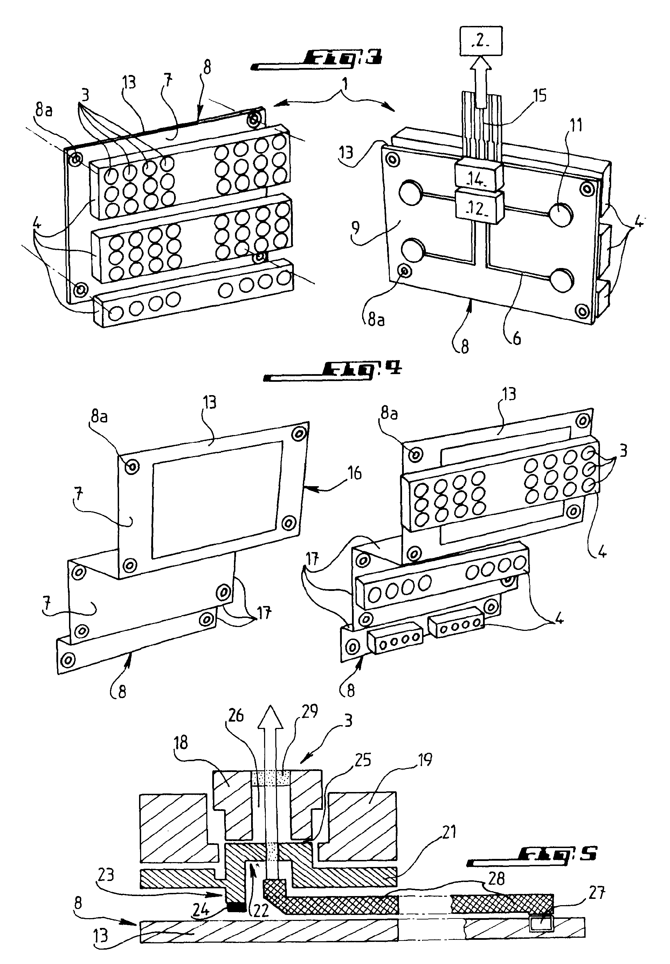

On connaît un tel dispositif 1 représenté sur les figures 1 et 2, contrôlant et/ou commandant les équipements 2 d'un véhicule tels que la climatisation de l'habitacle, l'autoradio ou le système de verrouillage des portes du véhicule.

Ce dispositif 1 comprend des boutons de contrôle et/ou de commande 3 organisés en matrices 4, chacune utilisée comme interface mécanique entre un utilisateur et une base technique 5 relative à un équipement particulier 2.

Un circuit imprimé 6 est interposé entre chaque matrice 4 de boutons 3 et la base technique associée, les boutons 3 des matrices 4 étant électroniquement connectés au circuit 6 qui leur est propre, notamment par l'intermédiaire des contacteurs 6a, comme visible figure 2.

Ces dispositifs connus présentent de nombreux inconvénients.

Tout d'abord, leur utilisation multiplie le nombre de contacteurs ou de sources de lumière dont chacun des boutons formant l'interface mécanique peut être équipé.

D'autre part, ces circuits imprimés et les interfaces mécaniques associées sont difficilement intégrables aux différents modèles d'une même gamme de véhicule dont les planches de bord peuvent présenter des formes variables.

Enfin, le nombre important de circuits imprimés utilisés augmente considérablement les coûts de fabrication et le temps de montage.

Le but de l'invention est de remédier à ces inconvénients en proposant un dispositif de contrôle et/ou de commande d'équipements d'un véhicule automobile, caractérisé en ce qu'il comprend une dalle tactile comprenant une face active en regard de laquelle sont disposés en façade de la planche de bord du véhicule des matrices de boutons de contrôle et/ou de commande des équipements, ces boutons pouvant être sélectivement actionnés manuellement par un utilisateur pour produire une onde acoustique se propageant sur la face active, et en ce que la dalle tactile comprend, à sa face opposée à la face active, un ou plusieurs capteurs de détection d'onde acoustique et une unité électronique de traitement reliée aux capteurs par un circuit imprimé pour localiser la zone de la face active d'où provient l'onde détectée et contrôler et/ou commander l'équipement associé à cette zone.

Selon une autre caractéristique, la dalle est plane et comprend également une partie non plane thermoformée prolongeant la dalle plane pour épouser la forme de la planche de bord et comprenant également des matrices de boutons de contrôle et/ou de commande situés en regard de la face active de la partie non plane de la dalle tactile.

Les matrices de boutons de contrôle et/ou de commande sont avantageusement associées respectivement aux différents équipements.

Selon une autre caractéristique, les boutons de contrôle et/ou de commande sont des boutons poussoirs, chacun comprenant une touche logée de façon imperdable dans un boîtier fixé relativement à la dalle tactile, la face active de la dalle est surmontée d'une membrane élastiquement déformable comprenant à l'aplomb de la touche un doigt orienté vers la face active et dont l'extrémité libre pourvue d'un tampon rigide est espacée de la face active en position de repos du bouton, de sorte q'une pression d'enfoncement de la touche d'un bouton vers la face active déforme élastiquement la membrane pour que le tampon du doigt sous-jacent percute une zone de la face active et génère une onde acoustique se propageant à partir de la zone heurtée.

Au moins l'un des boutons comprend avantageusement un canal central perpendiculaire à la dalle, et fermé à son extrémité opposée à la dalle par un bouchon de diffusion de lumière, la dalle comprend au moins une source de lumière dont la lumière est acheminée par un guide de lumière au travers du canal du bouton et au travers de son bouchon de diffusion de la lumière.

D'autres caractéristiques et avantages de l'invention ressortiront clairement de la description qui en est faite ci-dessous, à titre indicatif et nullement limitatif, en référence aux figures annexées, parmi lesquelles :
- la figure 1 est un schéma de principe en perspective d'un dispositif de contrôle et/ou de commande de l'art antérieur ;
- la figure 2 est une vue en coupe d'un bouton poussoir faisant partie de la figure 1 ;
- la figure 3 représente en perspective un premier mode de réalisation d'un dispositif de contrôle et/ou de commande à dalle tactile, selon l'invention ;
- la figure 4 est une variante de réalisation de la dalle tactile de la figure 3 ;
- la figure 5 est une vue en coupe d'un bouton poussoir faisant partie de la figure 3 ou 4.

Comme pour le dispositif des figures 1 et 2, le dispositif 1 de contrôle et/ou de commande d'équipements de l'invention représenté aux figures 3 à 5, est destiné à équiper un véhicule automobile, au niveau de sa planche de bord, en étant accessible en façade de cette planche de bord pour permettre au conducteur et/ou aux passagers du véhicule de contrôler et/ou commander les équipements 2 du véhicule.

À titre d'exemple, ces équipements 2 peuvent être constitués par un autoradio et un appareil de climatisation de l'habitacle du véhicule.

Selon l'invention, le dispositif 1 comprend des boutons de contrôle et/ou de commande 3 regroupés en trois matrices 4, formant chacune une façade mécanique intégrée à la planche de bord en regard de la face active 7 d'une dalle tactile 8, comprenant à sa face opposée 9 des capteurs de détection 11 d'une onde acoustique générée sur la face active 7 comme on le verra ultérieurement, et une unité électronique 12.

La dalle tactile 8 est avantageusement constituée par une plaque 12 sensiblement rectangulaire de résine époxy, en étant fixée à la planche de bord du véhicule au moyen des plots de fixation 8a.

Ce matériau présente l'avantage de produire des signaux complexes sous forme d'onde acoustique lorsqu'il est soumis à des impacts sur la zone active sollicitée générant une onde qui lui est propre.

Les impacts sont produits par l'actionnement sélectif des boutons de contrôle et/ou de commande 3 situés en regard de la face active 7 de la dalle tactile 8.

Les ondes sont détectées par les capteurs 11 ou accéléromètres, du type piézoélectrique, captant les moindres vibrations auxquelles la face active 7 est soumise.

Les capteurs 11 transmettent un signal représentatif de l'onde détectée à l'unité de traitement du signal 12 adaptée pour comparer ce signal à une base de données de signaux préalablement enregistrés pour chacune des zones de la dalle tactile, afin de localiser ladite zone sollicitée.

L'unité de traitement 12 transmet une information relative à la zone sollicitée à un convertisseur 14 fixé sur la face opposée 9 de la dalle tactile 8, relié à un réseau de trames de type CAN 15, pour contrôler et/ou commander l'équipement 2 correspondant au bouton 3 sélectionné par l'utilisateur et appartenant à la matrice 4 associée à cet équipement 2.

Comme représenté sur la figure 3, la dalle tactile 8 peut avantageusement comporter une partie plane dite partie électronique 16, sur laquelle sont fixés les capteurs 11, le circuit imprimé 6, l'unité de traitement 12 et le convertisseur 14.

Cette partie électronique 16 est de préférence plane afin de ne pas fragiliser les connections du circuit imprimé 6 ou endommager le fonctionnement des composants électroniques 11, 12, 14 précités.

La dalle tactile 8 peut comporter une partie non plane 17, prolongeant la partie électronique 16 mais qui présente la particularité et l'avantage de pouvoir être mise en forme afin d'épouser par exemple la forme de la planche de bord, ou toute autre forme pratique et/ou esthétiquement satisfaisante, comme visible sur la figure 4.

À cet effet, la résine constitutive de la plaque 13 présente des propriétés lui permettant d'être déformée par exemple sous l'action de la chaleur et d'être mise en forme par un procédé de thermoformage.

De plus, les impacts occurant à la surface de cette partie non plane 17 restent détectables par les capteurs 11 de la partie électronique 16 de la dalle 8, permettant à cette partie non plane 17 d'assurer la fonction de face active 7, malgré son éloignement par rapport aux capteurs de détection 11.

De ce fait, la partie non plane 17 peut également accueillir les matrices 4 de boutons 3.

Les boutons 3 d'une même matrice 4 peuvent être regroupés par groupes de contrôle et/ou de commande : un groupe de boutons permettant de contrôler le volume d'un autoradio, un autre groupe de boutons 3 ajustant la fréquence de réception d'un canal de l'autoradio et un autre groupe permettant de contrôler la lecture d'un disque compact.

Selon le premier mode de réalisation représenté en figure 5, chaque bouton est du type bouton poussoir 3 comprenant une touche 18 logée de façon imperdable au sein d'un boîtier 19 fixé en regard de la face active 7 de la dalle tactile 8 et pouvant être manuellement enfoncé.

Une membrane élastiquement déformable 21, avantageusement en silicone, est intercalée entre chaque bouton poussoir 3 et la face active 7 sous-jacente, en s'étendant sensiblement parallèlement à la face active 7.

La partie de membrane 21 située à l'aplomb de chaque touche 18 comprend un bossage 22, dirigé vers la touche 18.

Chaque bossage 22 comprend un doigt 23 pointant vers la face active 7, en étant espacé de cette dernière.

Le doigt 23 comprend à son extrémité libre un tampon rigide 24 par exemple à base de matériau carboné, dit tampon carbone, permettant de générer un impact net sur la zone sous-jacente.

Lorsque l'utilisateur enfonce la touche 18 du bouton poussoir 3, la face inférieure 25 de la touche 18 en contact avec le bossage 22 exerce un effort sur ce dernier à l'encontre de sa force élastique de rappel, permettant au tampon 24 du doigt 23 d'entrer en collision avec la face active 7 sous-jacente, créant ainsi l'impact net qui génère une onde acoustique se propageant à partir de la zone sous-jacente.

Les boutons 3 peuvent avantageusement être utilisés comme témoin visuel d'activation et comporter à cet effet un canal 26 perpendiculaire à la dalle 8 traversé par de la lumière lorsqu'un contrôle et/ou une commande d'un équipement 2 du véhicule est activé, tel que l'allumage des feux de détresse, la fonction de désembuage du véhicule, ou encore l'allumage des feux anti-brouillard. La partie électronique 16 de la dalle 8 comporte des sources de lumière 27, telles que des diodes électroluminescentes, dont la lumière est acheminée vers les boutons témoins d'activation 3 par des guides de lumière 28, tels que des fibres optiques, interposés entre la membrane 21 et la face active 7. Ces guides 28 comprennent une extrémité 33 située au contact de la source de lumière 27, l'autre extrémité 34 débouchant sur une partie transparente du bossage 22 de la membrane 21 et laissant passer la lumière vers le canal 26, avantageusement fermé à son extrémité opposée à la dalle 8 par un bouchon de diffusion de lumière 29.

Différents types de boutons de contrôle et/ou de commande, non représentés aux figures, peuvent également être intégrés au sein des matrices 4 de boutons 3, tels que des boutons poussoir à membrane souple, des boutons à lame vibrant sous l'action d'une touche de sollicitation, ou des boutons de type molette ou curseur, à doigt d'indexation surmontant une face active ondulée le long du parcours de ce doigt.

L'ensemble non exhaustif de ces boutons peut bien évidemment être illuminé par une source de lumière, comme décrit plus haut.

Le dispositif de l'invention reprend ainsi en combinaison la technique de la dalle tactile associée à des boutons de contrôle et/ou de commande à action purement mécanique, et la technologie des circuits imprimés, pour simplifier les connections électroniques, l'assemblage du dispositif et permettre une souplesse de présentation des interfaces mécaniques visibles par l'utilisateur par la possibilité de positionner librement les différents boutons suivant le style de présentation souhaité.

## Revendications

1. Dispositif de contrôle et/ou de commande d'équipements (2) d'un véhicule automobile, comprenant une dalle tactile (8) pourvue d'une face active (7) en regard de laquelle sont disposés en façade de la planche de bord du véhicule des matrices (4) de boutons de contrôle et/ou de commande (3) des équipements (2), ces boutons (3) pouvant être sélectivement actionnés manuellement par un utilisateur pour produire une onde acoustique se propageant sur la face active (7), la dalle active (8) étant pourvue à sa face opposée à la face active (7), d'un ou plusieurs capteurs (11) de détection d'onde acoustique et d'une unité électronique de traitement (12) reliée aux capteurs (11) par un circuit imprimé (6) pour localiser la zone de la face active (7) d'où provient l'onde détectée et contrôler et/ou commander l'équipement (2) associé à cette zone, **caractérisé en ce que** la dalle (8) est plane et comprend également une partie non plane (17), avantageusement thermoformée, prolongeant la dalle plane (16) pour épouser la forme de la planche de bord et comprenant également des matrices (4) de boutons de contrôle et/ou de commande (3) situés en regard de la face active (7) de la partie non plane (17) de la dalle tactile (8).

2. Dispositif selon la revendication 1, **caractérisé en ce que** les matrices (4) de boutons de contrôle et/ou de commande (3) sont associées respectivement aux différents équipements (2).

3. Dispositif selon la revendication 1 ou 2, **caractérisé en ce que** les boutons de contrôle et/ou de commande (3) sont des boutons poussoirs, chacun comprenant une touche (18) logée de façon imperdable dans un boîtier (19) fixé relativement à la dalle tactile (8), **en ce que** la face active (7) de la dalle (8) est surmontée d'une membrane élastiquement déformable (21) comprenant à l'aplomb de la touche (18) un doigt (23) orienté vers la face active (7) et dont l'extrémité libre pourvue d'un tampon rigide (24) est espacée de la face active (7) en position de repos du bouton (3), de sorte qu'une pression d'enfoncement de la touche (18) d'un bouton (3) vers la face active (7) déforme élastiquement la membrane (21) pour que le tampon (24) du doigt sous-jacent (23) percute une zone de la face active (7) et génère une onde acoustique se propageant à partir de la zone heurtée.

4. Dispositif, selon l'une quelconque des revendications 1 à 3, **caractérisé en ce qu'**au moins l'un des boutons (3) comprend un canal central (26) perpendiculaire à la dalle (8), et fermé à son extrémité opposée à la dalle (8) par un bouchon de diffusion de lumière (29), et **en ce que** la dalle (8) comprend au moins une source de lumière (27) dont la lumière est acheminée par un guide de lumière (28) au travers du canal (26) du bouton (3) et de son bouchon de diffusion de la lumière (29).
